# EUROPEAN PATENT SPECIFICATION

(11) **EP 2 485 395 B1**
(45) Date of publication and mention of the grant of the patent: **01.05.2013**
(21) Application number: 11153360.0
(22) Date of filing: 04.02.2011
(51) Int. Cl.: H03G 7/00, H03M 1/18, H03G 3/30

(54) **Audio Mixing Console avoiding Signal Level Overload**
Audiomischkonsole, die eine Signalpegelüberlastung vermeidet
Console de mélange audio évitant une surcharge du niveau sonore

(43) Date of publication of application: 08.08.2012
(73) Proprietor: Harman International Industries Ltd., Potters Bar Hertfordshire EN6 3JN (GB)
(72) Inventor: Ayres, Richard, Stevenage, SG2 8SJ (GB)
(74) Representative: Bertsch, Florian Oliver

(56) References cited:
- WO-A1-2006/122389
- GB-A- 2 297 443
- US-B1- 6 741 194

## Description

### Technical Field

The present invention relates to an audio mixing console and to a method for operating an audio mixing console.

### Related Art

Overloading the audio input to an audio mixing console, particularly analogue input, will result in overload and clipping with its accompanying undesirable side-effects. Clipping occurs when an amplifier attempts to deliver an output signal beyond its maximum capacity, a method and an audio system able to prevent overload of an analogue input stage of an audio mixing console without effecting the overall system gain would be a great practical benefit to consumers. With analogue technologies it would be difficult, if not impossible, to design a solution to this problem. Detection of overload would be hard to measure and inflexible to changing user needs and requirements and with fairly rigid system constraints on maximum internal operating levels (approximately 21 dBu, dBu indicating that the reference quantity is 0,775 Volts root mean square) and minimum noise floor (of approximately 86 dBu). There is little scope to replace any gain that can be taken away from the input amplifier to restore the required overall system gain. Further problems arise in the analogue domain since it is frequently difficult, if not impossible, to automate any change without significant cost.

WO 2006/ 122389 A1 discloses a system detecting desired and undesired sources of gain adjustment to achieve an appropriate level defined by the system design.

US 5,821,889 discloses an apparatus for automatic clip level adjustment, wherein the signal of the digital audio signal is compared to upper and lower limits of an acceptable range of signal magnitude. If the determined signal magnitude is greater than the upper limit, the magnitude or gain of the audio signal is automatically reduced and the magnitude or gain of the analogue output signal is correspondingly increased.

WO 02/17496 discloses a method for avoiding clipping, in which either an analogue signal is decreased by a fixed amount and the signal is increased again later on by the same amount.

### Summary

Summarising, a need exists to provide a possibility to minimise an overload situation of an audio input signal input to an audio mixing console wherein the amount of overload should be determined precisely.

This need is met by the features of the independent claims. In the dependent claims preferred embodiments of the invention are described.

According to a first aspect an audio mixing console is provided comprising a first amplifier receiving an analogue audio input signal configured to amplify the received audio input signal with a first adjustable gain. Further, an analogue to digital converter is provided receiving the amplified analogue audio input signal, the converter being configured to generate a digital audio signal by analogue to digital conversion of the amplified analogue audio signal. Furthermore, a second amplifier is provided receiving the digital audio signal, the second amplifier being configured to amplify the received digital audio signal with a second adjustable gain. The mixing console further comprises a gain range control unit configured to identify a signal level overload at the analogue to digital converter, and configured to control the gain of the first and second amplifier respectively. When the gain range control unit identifies an occurrence of signal level overload, it reduces the first gain, at the first amplifier, by a first amount and increases the second gain, at the second amplifier, by the first amount. The above-described mixing console allows the system gain and peak signal levels to be preserved in order to minimise the impact on level or balance of any mixes made from a combination of input sources. Furthermore, with the console an almost totally distortion free environment can be guaranteed and it can help to reduce damage to speaker components that could occur in high distortion environments. As the analogue audio input signal is converted to a digital signal the provided digital signal offers an opportunity to address the problem as mentioned in the introductory part since, in the digital domain automated control of parameters is possible in easily defined and measured steps. The occurrence of the signal level overload can be determined at the AD (analogue to digital) converter.

In one embodiment the first gain at the first amplifier is reduced directly after identifying the occurrence of a signal level overload. The gain control unit then furthermore detects whether the signal overload is still present at the analogue to digital converter. If this is the case the first gain at the first amplifier is reduced by the first amount and the second gain at the second amplifier is increased by the first amount until the signal level overload is not detected anymore.

In another embodiment the gain range control unit is configured to estimate an amount of signal level overload, wherein, when the signal level overload is detected, the gain range control unit estimates the amount of signal level overload and reduces the first gain at the first amplifier in dependence on the estimated signal level overload by the first amount and increases the second gain at the second amplifier by the same amount.

In one embodiment it is possible that the gain range control unit is configured to identify the signal level overload by determining whether the signal level of the digital audio signal is higher than a predefined first threshold and by determining whether a number of consecutive audio signal samples of the predefined first threshold is higher than a predefined second threshold, wherein the gain range control unit can identify the occurrence of the signal level overload situation when a number of consecutive samples having a signal level above the first threshold is higher than the second threshold. The first threshold and the second threshold, i.e. the maximum signal level and the number of signal samples over the maximum signal level, can be determined by the user. As a consequence, the mixing console offers the user a possibility to set his/her own definition of overload within prescribed and defined ranges. The user can determine according to his/her needs that a signal at or in the AD converter is overloading or is at risk of overloading. The definition of overload may be defined by absolute events such as "two or more consecutive samples above the first threshold", or above "a full-scale deflection" or "two or more samples of greater amplitude than the defined overload threshold". The user can furthermore define parameters such as "how many consecutive overload samples may occur over a given period of time before the gain range control unit reacts by reducing the first gain and by increasing the second gain by the same amount". The determination of the signal level overload situation can be helpful for preventing very small samples from triggering the gain range control unit to reduce the first gain in events such as a microphone being dropped. The analogue audio input signal can be a signal coming from a microphone. Especially in wireless microphones, where the initial input gain is frequently set on the transmitter device and where there is no mechanism for the mixing console operator to reduce this gain in the event that audio levels result in overload of the wireless system, the present invention can help to avoid these situations.

According to the invention the signal level overload is determined by the gain range control unit by interpolating a signal level evolution of the digital audio signal using a signal level evolution of a predefined number of last detected signal samples. The gain range control unit can then determine by which amount the digital audio signal would have been higher than the predefined first threshold. The gain range control unit can then reduce the first gain by the determined amount and can increase the second gain by the determined amount in order to avoid the signal level at the AD converter being higher than the predefined first threshold. However, in another embodiment it is also possible that the gain range control unit extrapolates the signal level evolution based on the predefined number of last detected signal samples. In this situation a future overload may be detected before it actually happens. For determining by which amount the signal would have been higher than the predefined first threshold the gain range control unit is configured to interpolate the signal level evolution, taking into account a rise time of the signal level in a predefined number of last signal samples and/or taking into account a number of signal samples above the predefined threshold.

In one embodiment it is possible that the gain range control unit determines the first amount of gain reduction in such a way that the signal level of the digital audio signal at the analogue to digital converter is lower than a predefined peak signal level. This predefined peak signal level can be the signal level where clipping would occur or can be any other signal level.

The invention furthermore relates to a method for operating an audio mixing console, the method comprising the steps of amplifying, by a first amplifier, an analogue audio input signal with a first adjustable gain. The amplified analogue audio input signal is then converted to a digital audio signal by the analogue to digital converter, the digital audio signal being amplified by a second amplifier. Furthermore, a signal level overload is identified at the analogue to digital converter and the amount of signal level overload is estimated when the signal level overload has been identified. The amount of signal level overload is estimated and the first gain at the first amplifier is reduced in dependence on the estimated signal level overload by a first amount and the second gain at the second amplifier is increased by the same amount. This method helps to preserve the overall system gain and helps to preserve the dynamics of the original signal.

### Brief description of the drawings

The invention will be described in further detail with reference to the accompanying drawings, in which
Fig. 1 shows a signal evolution of an audio signal in a digital mixing console where the signal level and the gain remains below any overload or clipping threshold,
Fig. 2 shows a signal evolution of an audio signal when the signal level and gain would result in an overload situation,
Fig. 3 shows a schematic mixing console where the gain range is automatically controlled according to the invention,
Fig. 4 shows a flowchart indicating the steps for controlling or avoiding a signal level overload,
Fig. 5 schematically shows how the overload at the analogue to digital converter is determined, and
Fig. 6 shows a flowchart indicating another embodiment for controlling a signal level overload.

### Detailed description

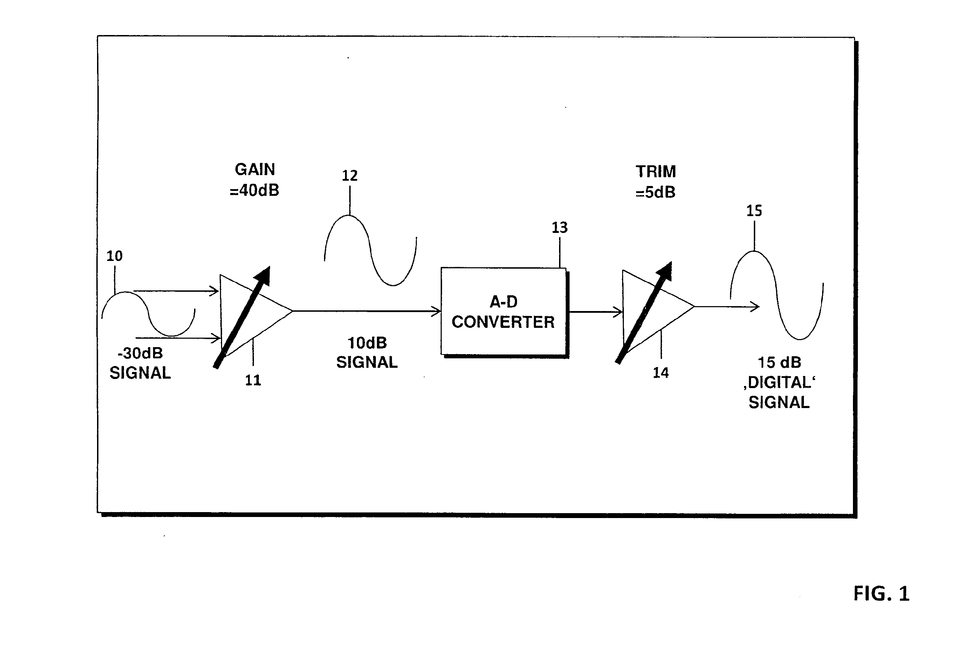

In Fig. 1 an audio mixing console is schematically shown. In the embodiments shown in the Figs. only the components of the audio mixing console necessary for the understanding of the invention are described, other components being omitted for the sake of clarity. An audio input signal 10, e.g. a microphone signal, is fed via an input of the audio mixing console (not shown) to a first amplifier 11 with an adjustable gain. In the embodiment shown the audio input signal is a -30dB signal. With a gain of 40dB an audio output signal 12 of +10dB is obtained that is fed to an analogue to digital converter 13. The digital audio signal is then transmitted to a second amplifier 14 where a second amplification is carried out, e.g. by 5dB resulting in a digital audio signal 15 having 15dB.

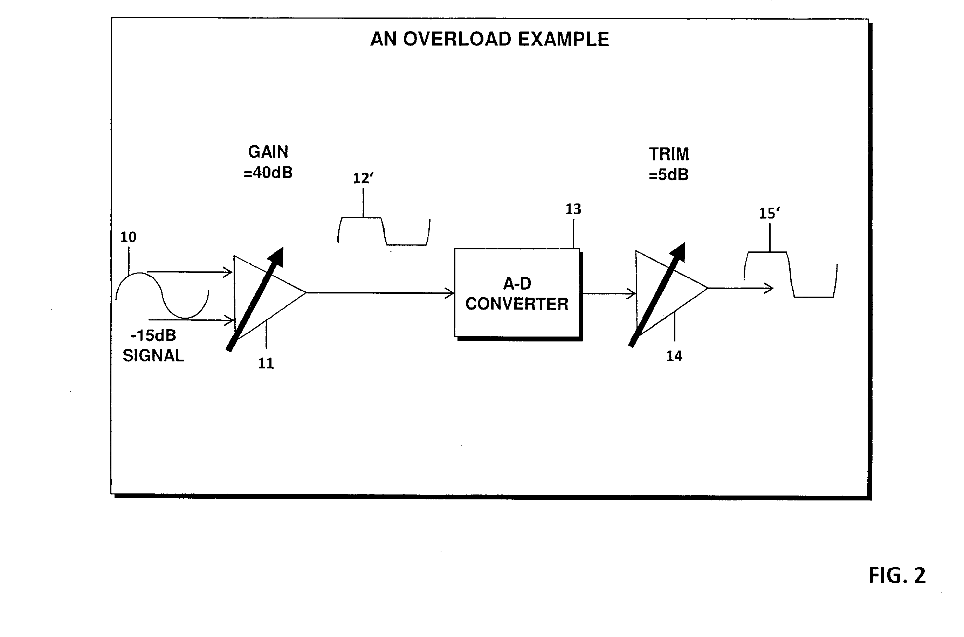

In connection with Fig. 2 an overload situation is explained in more detail. The audio input signal 10, in the example shown having -15dB is fed to the first adjustable amplifier 11 where a gain of 40dB is obtained. The analogue to digital converter 13 may have a maximum input level of +20dB. With the gain of 40dB after the first amplifier 11 the signal attempts to reach +25dB. However as the AD converter can only process signals at +20dB a clipped audio signal 12' is obtained. After the second amplifier the distorted audio signal 15' would be obtained.

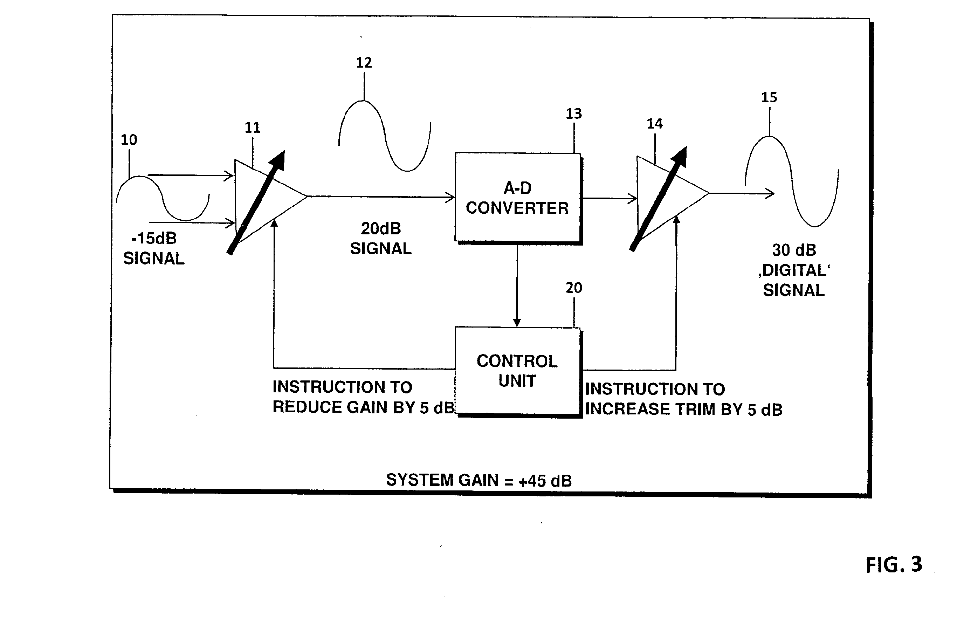

In Fig. 3 an audio mixing console is shown with which the overload situation discussed above in connection with Fig. 2 can be avoided. The audio input signal 10 with a signal of -15dB is input into the first amplifier 11 where the signal should be amplified with a gain of +40dB resulting in an amplified signal 12 of 25dB. However, as the maximum input level of the AD converter 13 is 20dB, clipping would occur. This overload situation is detected by a gain range control unit 20 which detects an overload situation at the AD converter. The user of the system shown in Fig. 3 can define rules to determine when overloading occurs at the converter 13. The user can set a peak signal level as a first threshold. Secondly the user can set a number of samples with a signal level higher than the first threshold, this number of samples being the second threshold. Based on these two parameters an overload situation may be detected by the gain range control unit. By way of example, if two or more consecutive samples at full-scale deflection are detected, an overload situation may exist. In the AD converter a full-scale deflection occurs when the audio signal has reached the maximum representable value. If the control unit now has detected an overload situation at the AD converter, the control unit can control the first amplifier by instructing the first amplifier to reduce the gain in order to avoid the overload situation. In the example shown the control unit 20 may reduce the +40dB setting to +35dB analogue gain resulting in the 20dB audio signal 12. This signal can then be processed correctly by the AD converter 13. At the same time the control unit 20 can instruct the second amplifier 14 to increase the amplification by the same amount, here 5dB. Instead of the originally intended +5dB the amplification is then 10dB resulting in a 30dB digital signal 15 at the output.

In the embodiment shown the input gain control of amplifier 11 occurs automatically, however, the principle discussed above can also be used on systems with manually adjustable gain controls in which the control unit 20 is used to advise the operator on a recommended action.

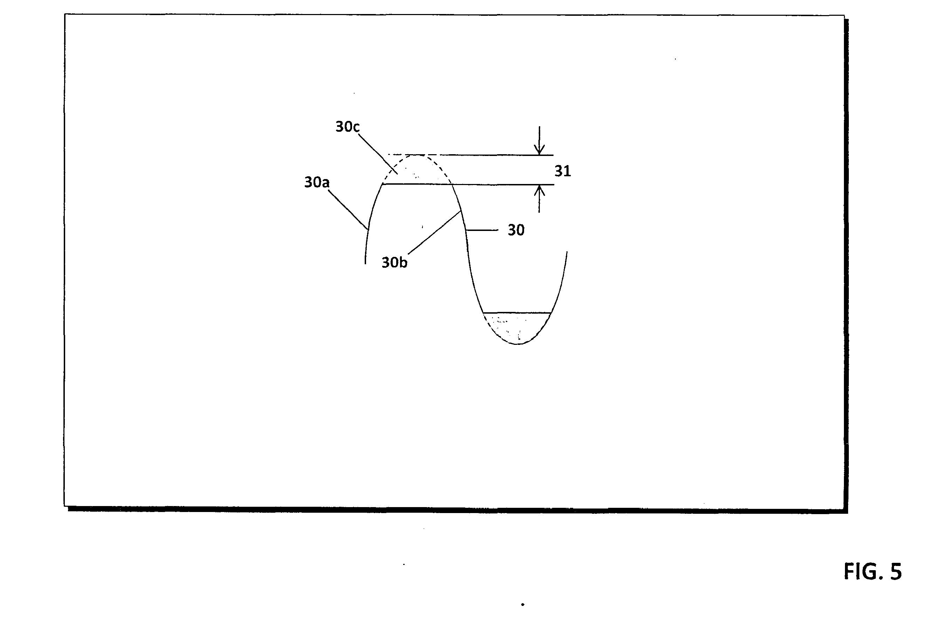

The method for determining a signal level overload by the control unit 20 is based on interpolation as will be described in connection with Fig. 5 in more detail. In Fig. 5 an audio signal 30 is shown for which an overload situation would occur at the analogue to digital converter. Based on the rise time at sections 30a and 30b and based on the number of signal samples at full-scale deflection in section 30c the control unit can determine the maximum level of the audio signal as indicated by the dashed lines. The amount of signal level overload 31 can be estimated and the amplification of the first amplifier can be reduced by the determined amount of signal level overload. Simultaneously the gain of the second amplifier can be increased by the same amount. In the embodiment shown in Fig. 5 the control unit uses the result of the estimation of the amount of signal level overload to take proactive action. In this embodiment only the signal evolution of section 30a may be used to extrapolate the signal evolution. In this situation the system reacts before the overload actually occurs. In another embodiment the overload situation as shown in Fig. 5 may have occurred and the result of the estimation based on sections 30a and 30b of the signal level overload can be used to take reactive action.

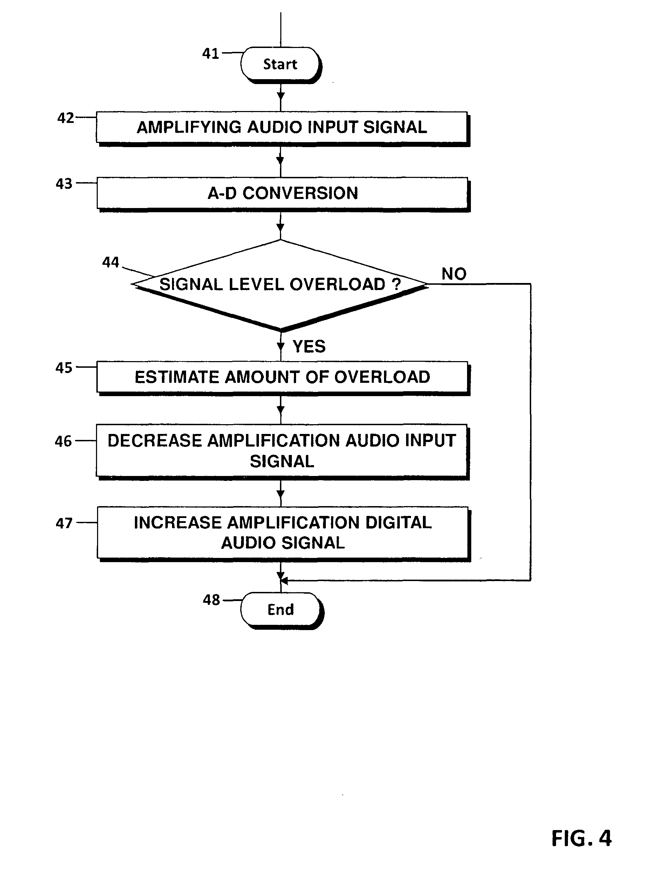

In Fig. 4 the steps for controlling a signal level in an audio mixing console according to a first embodiment are summarised. The method starts in step 41 and in step 42 the audio input signal is amplified at the first amplifier 11. In step 43 the analogue to digital conversion is carried out at AD converter 13. In the next step 44 the gain range control unit 44 determines whether a signal level overload situation can be identified. The way in which such a signal level overload situation can be detected was discussed above in connection with Fig. 5. If a signal level overload has been detected the amount of signal level overload is estimated in step 45. In the next step 46 the amplification of the audio input signal at the first amplifier is reduced in such a way that the overload is avoided and at the same time in step 47 the amplification of the digital audio signal at the second amplifier 14 is increased by the same amount. If no signal overload situation is detected in step 44, the control of the two amplification stages is not necessary and the signal can be provided for further processing without any additional steps. The method ends in step 48.

In the embodiment of Fig. 4 the amount of signal level overload was estimated before the system i.e. the gain range control unit reacted. In another embodiment there is no estimation of the signal level overload and the system, the gain range control unit, simply reduces the gain at the first amplifier by the first amount and increases the gain at the second amplifier by the second amount. If the overload continues the same process is repeated until the overload situation is not detected anymore.

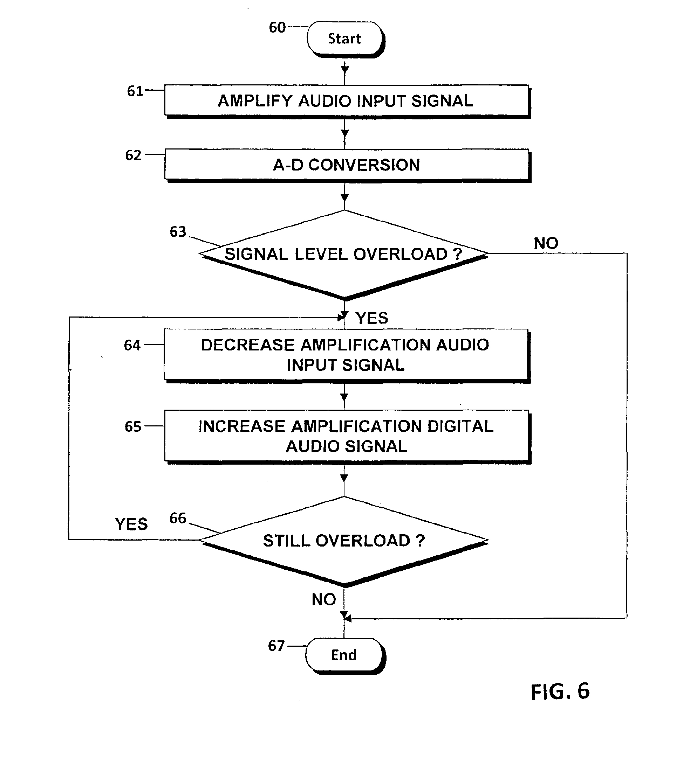

This embodiment is disclosed in more detail in Fig. 6. The method starts in step 60. In step 61 the audio input signal is amplified and in step 62 the analogue to digital conversion takes place. These two steps correspond to steps 42 and 43 of Fig. 4. Furthermore, in step 63, it is checked whether an overload situation at the analogue to digital converter exists. If an overload situation is detected, the amount of overload is not detected as in Fig. 4, but the amplification of the audio input signal is directly decreased by a first amount and the digital audio signal amplification is increased by the second amount (step 65). In the next step 66 it is then checked whether the overload situation still applies. If yes, steps 64 and 65 are repeated until no overload situation is detected at step 66 anymore, the method ending in step 67.

The adaptation described above may be used with user adjustable parameters to set the sensitivity and the aggression of the gain adaptation to suit local conditions, environments or requirements. The present invention can help to reduce damage to speaker components that could occur in higher distortion environments. Furthermore, a maximum gain is possible without compression or changing of the desired overall system gain. The gain at the first amplifier is reduced by a defined number of dB while simultaneously increasing the trim by a corresponding number of dB at the second amplifier.

## Claims

1. An audio mixing console comprising:
- a first amplifier (11) receiving an analogue audio input signal configured to amplify the received audio input signal (10) with a first adjustable gain,
- an analogue to digital converter (13) receiving the amplified analogue audio input signal configured to generate a digital audio signal by an analogue to digital conversion of the analogue audio signal,
- a second amplifier (14) receiving the digital audio signal configured to amplify the received digital audio signal with a second adjustable gain, and generating a digital output signal,
- a gain range control unit (20) configured to identify a signal level overload at the analogue to digital converter (13) and configured to control the gain of the first and second amplifier, respectively,
wherein the gain range control unit (20) configured to identify the signal level overload, is configured to interpolate a signal level evolution of the digital audio signal using a signal evolution of a predefined number of last detected signal samples and to determined by which amount the digital audio signal would be higher than a predefined first threshold, the gain range control unit (20) being configured to reduce the first gain by the determined amount and to increase the second gain by the determined amount, wherein the gain range control unit (20) is configured to interpolate the signal level evolution taking into account a rise time of the signal in the predefined number of last detected signal samples and/or a number of signal samples above the predefined first threshold.

2. The audio mixing console according to claim 1, wherein the gain range control unit (20) is configured to estimate an amount of signal level overload wherein, when a signal level overload is detected, the gain range control unit (20) estimates the amount of signal level overload and reduces the first gain at the first amplifier in dependence on the estimated signal level overload by the first amount.

3. The audio mixing console according to claim 1 or 2, wherein the gain range control unit (20) is configured to identify the signal level overload by determining whether the signal level of the digital audio signal is higher than a predefined first threshold and by determining whether a number of consecutive audio signal samples above the predefined first threshold is higher than a predefined second threshold, wherein the gain range control unit (20) identifies the occurrence of the signal level overload, when a number of consecutive samples having a signal level above the first threshold is higher than the second threshold.

4. The audio mixing console according to any of the preceding claims wherein the gain range control unit (20) determines the first amount of gain reduction in such a way that the signal level of the digital audio signal at the analogue to digital converter is lower than a predefined peak signal level.

5. A method for operating an audio mixing console, the method comprising the following steps:
- amplifying, by a first amplifier (11), an analogue audio input signal with a first adjustable gain,
- converting, by an analogue to digital converter (13), the amplified analogue audio input signal to a digital audio signal,
- amplifying, by a second amplifier (14), the digital audio signal with a second adjustable gain, and generating a digital output signal,
- identifying a signal level overload at the analogue to digital converter, the signal level overload is identified by interpolating a signal level evolution of the digital audio signal using a signal evolution of a predefined number of last detected signal samples and by determining by which amount the digital audio signal would be higher than a predefined first threshold, wherein the first gain is reduced by the determined amount and the second gain is increased by the determined amount, wherein the signal level evolution is interpolated taking into account a rise time of the signal in the predefined number of last detected signal samples and/ or a number of signal samples above the predefined first threshold.

6. The method according to claim 5, wherein an amount of signal level overload is estimated and the first gain at the first amplifier is reduced in dependence on the estimated signal level overload by the first amount.

7. The method according to claim 5 or 6, wherein the signal level overload is identified by determining whether the signal level of the digital audio signal is higher than a predefined first threshold and by determining whether a number of consecutive audio signal samples above the predefined first threshold is higher than a predefined second threshold, wherein the a signal level overload is detected when a number of consecutive samples having a signal level above the first threshold is higher than the second threshold.

8. The method according to any one of claims 5 to 7, wherein the first amount of gain reduction is determined in such a way that the signal level of the digital audio signal at the analogue to digital converter is lower than a predefined peak signal level.

9. The method according to claim 5, wherein, when the gain at the first amplifier has been reduced by the first amount, it is detected whether the signal level overload is still present at the analogue to digital converter, wherein in the affirmative, the first gain at the first amplifier is reduced by the first amount and the second gain at the second amplififer is increased by the first amount until the signal level overload is not detected anymore.

## Patentansprüche

1. Audiomischkonsole, umfassend:
- einen ersten Verstärker (11), der ein analoges Audioeingangssignal empfängt und dazu konfiguriert ist, das empfangene Audioeingangssignal (10) mit einer ersten einstellbaren Verstärkung zu verstärken,
- einen Analog-Digital-Umsetzer (13), der das verstärkte Audioeingangssignal empfängt und dazu konfiguriert ist, durch eine Analog-Digital-Umwandlung des analogen Audiosignals ein digitales Audiosignal zu erzeugen,
- einen zweiten Verstärker (14), der das digitale Audiosignal empfängt und dazu konfiguriert ist, das empfangene digitale Audiosignal mit einer zweiten einstellbaren Verstärkung zu verstärken und ein digitales Ausgangssignal zu erzeugen,
- eine Verstärkungsbereichsteuereinheit (20), die dazu konfiguriert ist, eine Signalpegelüberlastung am Analog-Digital-Umsetzer (13) zu identifizieren und dazu konfiguriert ist, die jeweilige Verstärkung des ersten und zweiten Verstärkers zu steuern,
wobei die Verstärkungsbereichsteuereinheit (20), die dazu konfiguriert ist, die Signalpegelüberlastung zu identifizieren, dazu konfiguriert ist, eine Signalpegelentwicklung des digitalen Audiosignals unter Verwendung einer Signalentwicklung einer im Voraus festgelegten Anzahl von zuletzt erkannten Signalabtastungen zu interpolieren und zu bestimmen, um wie viel das digitale Audiosignal höher als ein im Voraus festgelegter erster Schwellenwert wäre, wobei die Verstärkungsbereichsteuereinheit (20) dazu konfiguriert ist, die erste Verstärkung um die bestimmte Größe zu reduzieren und die zweite Verstärkung um die bestimmte Größe zu erhöhen, wobei die Verstärkungsbereichsteuereinheit (20) dazu konfiguriert ist, die Signalpegelentwicklung unter Berücksichtigung einer Anstiegszeit des Signals in der im Voraus festgelegten Anzahl von zuletzt erkannten Signalabtastungen und/oder einer Anzahl von Signalabtastungen oberhalb des im Voraus festgelegten Schwellenwerts zu interpolieren.

2. Audiomischkonsole nach Anspruch 1, wobei die Verstärkungsbereichsteuereinheit (20) dazu konfiguriert ist, eine Größe der Signalpegelüberlastung zu schützen, wobei die Verstärkungsbereichsteuereinheit (20) dann, wenn eine Signalpegelüberlastung erkannt wird, die Größe der Signalpegelüberlastung schätzt und die erste Verstärkung am ersten Verstärker in Abhängigkeit von der geschätzten Signalpegelüberlastung um die erste Größe reduziert.

3. Audiomischkonsole nach Anspruch 1 oder 2, wobei die Verstärkungsbereichsteuereinheit (20) dazu konfiguriert ist, die Signalpegelüberlastung zu identifizieren, indem sie bestimmt, ob der Signalpegel des digitalen Audiosignals höher als ein im Voraus festgelegter erster Schwellenwert ist, und indem sie bestimmt, ob eine Anzahl aufeinander folgender Audiosignalabtastungen oberhalb des im Voraus festgelegten ersten Schwellenwerts höher als ein im Voraus festgelegter zweiter Schwellenwert ist, wobei die Verstärkungsbereichsteuereinheit (20) das Auftreten einer Signalpegelüberlastung identifiziert, wenn eine Anzahl aufeinander folgender Abtastungen mit einem Signalpegel oberhalb des ersten schwellen Werts höher als der zweite Schwellenwert ist.

4. Audiomischkonsole nach einem der vorangehenden Ansprüche, wobei die Verstärkungsbereichsteuereinheit (20) die erste Größe der Verstärkungsreduzierung derart bestimmt, dass der Signalpegel des digitalen Audiosignals am Analog-Digital-Umsetzer unter einem im Voraus festgelegten Spitzensignalpegel liegt.

5. Verfahren zum Betreiben einer Audiomischkonsole, wobei das Verfahren folgende Schritte umfasst:
- Verstärken, durch einen ersten Verstärker (11), eines analogen Audioeingangssignals mit einer ersten einstellbaren Verstärkung,
- Umwandeln, durch einen Analog-Digital-Umsetzer (13), des verstärkten analogen Audioeingangssignals in ein digitales Audiosignal,
- Verstärken, durch einen zweiten Verstärker (14), des digitalen Audiosignals mit einer zweiten einstellbaren Verstärkung, und Erzeugen eines digitalen Ausgangssignals,
- Identifizieren einer Signalpegelüberlastung am Analog-Digital-Umsetzer, wobei die Signalpegelüberlastung identifiziert wird, indem eine Signalpegelentwicklung des digitalen Audiosignals unter Verwendung einer Signalentwicklung einer im Voraus festgelegten Anzahl zuletzt erkannter Signalabtastungen interpoliert wird, und indem bestimmt wird, um welche Größe das digitale Audiosignal höher als ein im Voraus festgelegter erster Schwellenwert wäre, wobei die erste Verstärkung um die bestimmte Größe reduziert wird und die zweite Verstärkung um die bestimmte Menge erhöht wird, wobei die Signalpegelentwicklung unter Berücksichtigung einer Anstiegszeit des Signals in der im Voraus festgelegten Anzahl von zuletzt erkannten Signalabtastungen und/oder einer Anzahl von Signalabtastungen oberhalb des im Voraus festgelegten Schwellenwerts interpoliert wird.

6. Verfahren nach Anspruch 5, wobei die Größe der Signalpegelüberlastung geschätzt wird und die erste Verstärkung am ersten Verstärker in Abhängigkeit von der geschätzten Signalpegelüberlastung um die erste Größe reduziert wird.

7. Verfahren nach Anspruch 5 oder 6, wobei die Signalpegelüberlastung identifiziert wird, indem bestimmt wird, ob der Signalpegel des digitalen Audiosignals höher als ein im Voraus festgelegter erster Schwellenwert ist, und indem bestimmt wird, ob eine Anzahl aufeinander folgender Audiosignalabtastungen oberhalb des im Voraus festgelegten Schwellenwerts höher als ein im Voraus festgelegter zweiter Schwellenwert ist, wobei eine Signalpegelüberlastung erkannt wird, wenn eine Anzahl aufeinander folgender Abtastungen mit einem Signalpegel oberhalb des ersten schwellen Werts höher als der zweite Schwellenwert ist.

8. Verfahren nach einem der Ansprüche 5 bis 7, wobei die erste Größe der Verstärkungsreduzierung derart bestimmt, dass der Signalpegel des digitalen Audiosignals am Analog-Digital-Umsetzer unter einem im Voraus festgelegten Spitzensignalpegel liegt.

9. Verfahren nach Anspruch 5, wobei dann, wenn die Verstärkung am ersten Verstärker um die erste Größe reduziert wurde, erkannt wird, ob die Signalpegelüberlastung am Analog-Digital-Umsetzer nach wie vor besteht, wobei dann, wenn dies zutrifft, die erste Verstärkung am ersten Verstärker um die erste Größe reduziert wird und die zweite Verstärkung am zweiten Verstärker um die erste Größe erhöht wird, bis die Signalpegelüberlastung nicht mehr erkannt wird.

## Revendications

1. Console de mélange audio comprenant :
- un premier amplificateur (11) recevant un signal audio analogique d'entrée, configuré pour amplifier le signal audio d'entrée reçu (10) selon un premier gain ajustable,
- un convertisseur analogique numérique (13) recevant le signal audio analogique d'entrée, configuré pour produire un signal audio numérique par une conversion analogique numérique du signal audio analogique,
- un deuxième amplificateur (14) recevant le signal audio numérique, configuré pour amplifier le signal audio numérique reçu selon un deuxième gain ajustable, et produisant un signal numérique de sortie,
- une unité (20) de régulation d'intervalle de gain, configurée pour identifier une surcharge de niveau de signal au niveau du convertisseur analogique numérique (13) et configurée pour réguler le gain du premier et du deuxième amplificateur, respectivement, dans laquelle l'unité (20) de régulation d'intervalle de gain, configurée pour identifier la surcharge de niveau de signal, est configurée pour interpoler l'évolution d'un niveau de signal du signal audio numérique à l'aide d'une évolution de signal d'un nombre prédéfini d'échantillons de derniers signaux détectés, et pour déterminer de quel montant le signal audio numérique doit dépasser un premier seuil prédéfini, l'unité (20) de régulation d'intervalle de gain étant configurée pour réduire le premier gain selon le montant déterminé, et pour accroître le second gain selon le montant déterminé, dans laquelle l'unité (20) de régulation d'intervalle de gain est configurée pour interpoler l'évolution du niveau de signal en prenant en compte un temps d'élévation du signal dans le nombre prédéfini d'échantillons de derniers signaux détectés et/ou dans un nombre d'échantillons de signaux situés au-dessus du premier seuil prédéfini.

2. Console de mélange audio selon la revendication 1, dans laquelle l'unité (20) de régulation d'intervalle de gain est configurée pour estimer un certain niveau de surcharge de niveau de signal, dans laquelle, lorsqu'une surcharge de niveau de signal est détectée, l'unité (20) de régulation d'intervalle de gain estime le montant de surcharge de niveau de signal et réduit du premier montant le premier gain, au niveau du premier amplificateur, en fonction de la surcharge estimée de niveau de signal.

3. Console de mélange audio selon la revendication 1 ou 2, dans laquelle l'unité (20) de régulation d'intervalle de gain est configurée pour identifier la surcharge de niveau de signal en déterminant si le niveau de signal du signal audio numérique est plus élevé qu'un premier seuil prédéfini et en déterminant si un certain nombre d'échantillons consécutifs de signaux audio situés au-dessus du premier seuil prédéfini est supérieur à un deuxième seuil prédéfini, dans laquelle l'unité de régulation d'intervalle de gain (20) identifie l'occurrence de la surcharge de niveau de signal, lorsqu'un certain nombre d'échantillons consécutifs à un certain niveau de signal supérieur au premier seuil dépasse le deuxième seuil.

4. Console de mélange audio selon l'une quelconque des revendications précédentes, dans laquelle l'unité (20) de régulation d'intervalle de gain détermine le premier montant de réduction de gain, de sorte que le niveau de signal du signal audio numérique au niveau du convertisseur analogique numérique est inférieur à un niveau prédéfini de pic de signal.

5. Procédé de fonctionnement d'une console de mélange audio, ce procédé comprenant les étapes suivantes :
- amplification, par un premier amplificateur (11), d'un signal audio analogique d'entrée selon un premier gain ajustable,
- conversion, par un convertisseur analogique numérique (13), du signal audio analogique d'entrée en un signal audio numérique,
- l'amplification, par un deuxième amplificateur (14), du signal audio numérique selon un deuxième gain ajustable, et la production d'un signal numérique de sortie,
- l'identification d'une surcharge de niveau de signal au niveau du convertisseur analogique numérique, la surcharge de niveau de signal étant identifiée par interpolation d'une évolution de niveau de signal du signal audio numérique à l'aide d'une évolution de signal d'un nombre prédéfini d'échantillons de derniers signaux détectés et par détermination du montant selon lequel le signal audio numérique doit dépasser un premier seuil prédéfini, dans lequel le premier gain est réduit selon le montant déterminé et où le deuxième gain est augmenté selon le montant déterminé, dans lequel l'évolution du niveau du signal est interpolée avec prise en compte d'un temps d'élévation du signal dans le nombre prédéfini d'échantillons de derniers signaux détectés et/ou d'un nombre d'échantillons de signaux au-dessus du premier seuil prédéfini.

6. Procédé selon la revendication 5, dans lequel un montant de surcharge de niveau de signal est estimé et où le premier gain au niveau du premier amplificateur est réduit en fonction de la surcharge estimée de niveau de signal selon le premier montant.

7. Procédé selon la revendication 5 ou 6, dans lequel la surcharge de niveau de signal est identifiée par détermination comme quoi le niveau de signal du signal audio numérique dépasse un premier seuil prédéfini et par détermination comme quoi un certain nombre d'échantillons consécutifs de signaux audio au-dessus du premier seuil prédéfini dépasse un deuxième seuil prédéfini, dans lequel la surcharge d'un niveau de signal est détectée quand un certain nombre d'échantillons consécutifs, dont le niveau de signal dépasse le premier seuil, dépasse le deuxième seuil.

8. Procédé selon l'une quelconque des revendications 5 à 7, dans lequel le premier montant de réduction de gain est déterminé de sorte que le niveau de signal du signal audio numérique au niveau du convertisseur analogique numérique est inférieur à un niveau prédéfini de pic de signal.

9. Procédé selon la revendication 5, dans lequel, quand le gain au niveau du premier amplificateur a été réduit d'un premier montant, il est détecté si la surcharge de niveau de signal est encore présente au niveau du convertisseur analogique numérique, dans lequel dans l'affirmative, le premier gain est réduit du premier montant au niveau du premier amplificateur, et où le second gain est augmenté du premier montant jusqu'à ce que la surcharge de niveau de signal ne soit plus détectée, au niveau du deuxième amplificateur.
